(19) Europäisches Patentamt

European Patent Office

Office européen des brevets

(11) **EP 1 093 231 A1**

(12) **DEMANDE DE BREVET EUROPEEN**

(43) Date de publication:
**18.04.2001 Bulletin 2001/16**

(51) Int Cl.⁷: **H03M 13/00**, H03M 13/25

(21) Numéro de dépôt: **00402797.5**

(22) Date de dépôt: **10.10.2000**

(84) Etats contractants désignés:
**AT BE CH CY DE DK ES FI FR GB GR IE IT LI LU MC NL PT SE**
Etats d'extension désignés:
**AL LT LV MK RO SI**

(30) Priorité: **12.10.1999 FR 9912710**

(71) Demandeur: **THOMSON-CSF**
**75008 Paris (FR)**

(72) Inventeur: **Laurent, Pierre-André,**
**Thomson-CSF P. I. Dept. Br.**
**94117 Arcueil Cedex (FR)**

(54) **Procédé de construction et de codage simple et systématique de codes Ldpc**

(57) Le procédé permet la construction de codes LDPC comportant N symboles dont K libres chaque code étant défini par une matrice de contrôle A comportant M=N-K lignes N colonnes et t symboles non nuls dans chaque colonne. Il consiste:

- à attribuer à toutes les lignes de la matrice de contrôle A un même nombre de symboles non nuls,
- à prendre comme nombre de symboles t un nombre impair le plus petit possible,
- à définir les colonnes de façon que deux colonnes quelconques de la matrice de contrôle A n'aient au plus qu'une valeur commune non nulle,
- et à définir les lignes de façon que deux lignes de la matrice de contrôle A n'aient qu'une valeur commune non nulle.

Application: Transmissions radio.

FIG.2

## Description

La présente invention concerne un procédé de construction et de codage simple et systématique de codes connus sous l'abréviation anglo-saxonne LDPC de "Low Density Parity Check".

Les codes de Gallager, proposés vers 1963, sont à l'origine des codes LDPC actuellement envisagés comme alternative aux turbo-codes.

Un article publié dans la revue IEEE Transaction on Information Theory Vol 45 n°2 Mars 1999 de M J C MacKay ayant pour titre "Good Error Correcting Codes Based on very Sparse Matrices" présente des résultats intéressants concernant ces codes, en particulier le fait que:

- ce sont asymptotiquement pour des blocs de taille élevée de "très bons codes"
- le décodage pondéré ("soft decoding", ou "décodage souple") est facile à mettre en oeuvre.

Mais il n'existe pas de méthode autre qu'heuristique pour les construire.

Suivant cette technique de codage un code (N, K) comportant N symboles dont K libres est défini par sa matrice de contrôle de parité A, comportant M = N - K lignes et N colonnes.

La matrice de contrôle A est caractérisée par sa faible "densité" : il faut entendre par là qu'elle comporte un nombre réduit d'éléments non nuls.

Plus précisément, elle comporte exactement t symboles non nuls dans chaque colonne, tous les autres étant égaux à 0.

Si les symboles d'un mot de code sont notés $c_i$, i = 0...N-1 et les éléments de la matrice de controle $A_{ij}$, le code satisfait M = N-K relations de la forme :

$$\Sigma_{i=0...N-1} \, A_{mi} \, c_i \text{ pour m=0...M-1}$$

Les méthodes proposées par M J C MacKay consistent à bâtir une matrice A initiale à partir de matrices unité ou tridiagonales plus petites, puis à permuter leurs colonnes pour arriver au résultat souhaité. L'expérience montre cependant qu'il est difficile de satisfaire les différentes contraintes imposées pour leur construction.

Le but de l'invention est de pallier les inconvénients précités.

A cet effet l'invention a pour objet, un procédé de construction de codes LDPC comportant N symboles dont K libres chaque code étant défini par une matrice de contrôle A comportant M=N-K lignes N colonnes et t symboles non nuls dans chaque colonne caractérisé en ce qu'il consiste :

a - à attribuer à toutes les lignes de la matrice de contrôle A un même nombre de symboles "t" non nuls,

b - à prendre comme nombre de symboles "t" un nombre impair le plus petit possible,

c - à définir les colonnes de façon que deux colonnes quelconques de la matrice de contrôle A n'aient au plus qu'une valeur non nulle,

d - et à définir les lignes de façon que deux lignes de la matrice de contrôle A n'aient qu'une valeur commune non nulle.

Le procédé selon l'invention a pour avantage qu'il permet de simplifier les algorithmes de codage et de décodage, en utilisant une matrice de contrôle A qui est la moins dense possible tout en donnant de bonnes performances pour une complexité raisonnable, la puissance de calcul nécessaire étant proportionnelle au nombre t. Dans la mesure où il y a peu d'erreurs, la contrainte "c" ci dessus permet à l'algorithme de décodage de toujours converger.

D'autres caractéristiques et avantages de l'invention apparaîtront à l'aide de la description qui suit faite en regard des dessins annexés qui représentent:

La figure 1 un tableau représentant une partition de la matrice de contrôle A.

Les figures 2 et 3 des groupements des $m^2$ sous matrices de gauche du tableau de la figure 1 en une sous matrice MxM et n-m sous-matrices MxP.

Les figures 4 et 5 une matrice de contrôle A obtenue respectivement selon une première et une deuxième variante d'exécution du procédé selon l'invention.

Les figures 6 à 9 une matrice de passage pour le calcul des symboles de redondance.

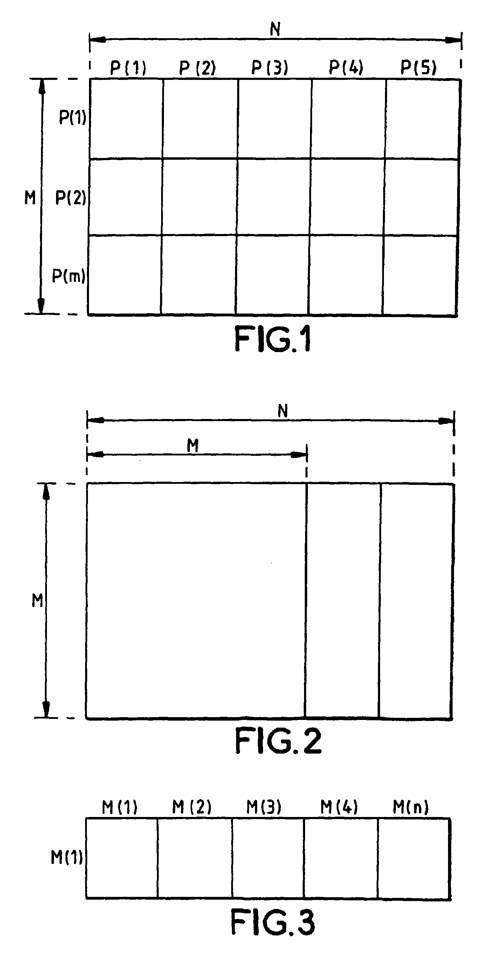

Pour la mise en oeuvre du procédé selon l'invention la matrice de contrôle, A, est subdivisée comme le montre la figure 1 en n sous-matrices de M lignes et P colonnes ou m x n sous-matrices carrées de P lignes et P colonnes telles que N=nP et M=mP et n et m premiers entre eux.

Les $m^2$ sous-matrices de gauche sont ensuite regroupées comme le montre la figure 2 en une sous-matrice M x M (ceci permettra de simplifier grandement l'algorithme de codage) et les autres en n - m sous-matrices M x P.

Le procédé de construction est décrit ci - après selon deux variantes, selon que m est égal à 1 ou t.

Les valeurs différentes de m ne sont pas à envisager ici, à cause de la condition "a" qui exige que tr soit entier. En effet, tr = t N / M, soit encore t n / m.

n et m étant premiers entre eux, m doit diviser t et ne peut donc être qu'égal à 1 ou t pour t premier et petit (vrai pour les faibles valeurs de t, à savoir 3, 5, 7).

Dans la première variante où m = 1 (codes de redondance r / (r - 1)),le procédé selon l'invention est valable pour les codes de taux de redondance N/K de la forme r / (r - 1), où le nombre de symboles de redondance est exactement N / r (r entier). Dans ce cas, M est égal à P et le tableau de la figure 2 se résume au tableau de la figure 3. Le procédé consiste alors à chercher n séquences de longueur M comportant t "1" et (M - t) "0".

Ces séquences notées ci-après w[0..n-1], sont obtenues par :

- une autocorrélation cyclique égale à 0, 1, ou t (la séquence i décalée ne coïncide avec elle-même non décalée qu'en 0 ou 1 point) telle que pour tout i = 0...n-1 :

$$\Sigma_{k=0....M-1} \; w[i][k] \; w[i][k] = t \text{ (par définition)}$$

$$\Sigma_{K=0..M-1} \; w[i][k] \; w[i][(k + p) \text{ modulo } M] = 0 \text{ ou } 1, \text{ pour } p = 1..M-1$$

- une intercorrélation cyclique égale à 0 ou 1 (la séquence i décalée ou non ne coïncide avec la séquence j qu'en 0 ou 1 point) telle que pour toute paire {i, j} où i = 0...n-1 et j = 0...n-1 sont différents :

$$\Sigma_{K=0....M-1} w[i][k] \; w[j][(k + p) \text{ modulo } M] = 0 \text{ ou } 1, \text{ pour } p = 0..M-1$$

L'algorithme de calcul des séquences w est très simple : il détermine successivement les positions pos[0][0... t-1], pos[1][0...t-1], ..., pos[n-1][0...t-1], où ces séquences possèdent un "1", en commen•ant par pos[x][0] = 0, pos[x] [1] = 1, ..., pos[x][t-1] = t-1, et en les modifiant pour satisfaire les conditions d'autocorrélation et intercorrélation.

Pour t = 3, les boucles de calcul mises en oeuvre sont montrées à l'annexe 1.

Cet algorithme échoue lorsque n est trop grand compte tenu de M : peu de "petits" codes sont trouvés, mais ceci est de peu d'importance car on cherche généralement des codes de grande taille (N >> 100).

Les colonnes de la matrice A sont alors tout simplement les vecteurs w permutés circulairement :

- kème sous-matrice (k = 0...n-1)
  A[ligne][colonne] = w[k][(ligne - (colonne - k P)) modulo M]
  Avec:
      ligne = 0...M-1
      et colonne = kP...(k + 1)P - 1

Ainsi, chaque ligne de A comporte exactement t valeurs non nulles dans chacune des n sous-matrices, soit un total de n = tr.

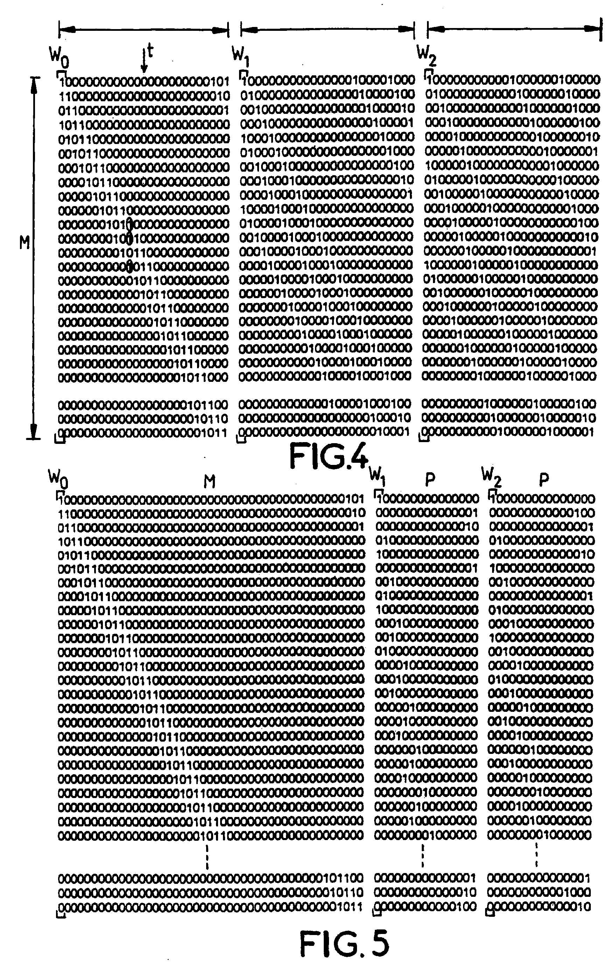

Un exemple de matrice A, obtenue par ce procédé pour un code LDPC(75, 50, t=3, tr=9) de redondance 3 / 2 (r = n = 3) avec P = 25 est montré à la figure 4. Selon le tableau représenté on peut constater que:

    w[0][i] = 1 pour i = 0, 1, 3
    w[1][i] = 1 pour i = 0, 4, 9
    w[2][i] = 1 pour = 0, 6, 13

La construction proposée garantit que :

- chaque colonne comporte exactement t valeurs non nulles (par définition des w)
- chaque ligne comporte exactement tr valeurs non nulles (grâce aux propriétés d'autocorrélation et intercorrélation des w)
- toute paire de colonnes distinctes a au maximum une valeur non nulle commune (idem)
- toute paire de lignes distinctes a au maximum une valeur non nulle commune (idem)

Selon une deuxième variante inspirée de la précédente correspondant au cas où m=t le procédé selon l'invention recherche n - m + 1 séquences de longueur M comportant t "1" et (M - t) "0", séquences notées w[0..n-m].

La première séquence, w[0] est obtenue par :

- une autocorrélation cyclique égale à 0, 1, ou t (la séquence 0 décalée ne coïncide avec elle-même non décalée qu'en 0 ou 1 point) telle que:

$$\Sigma_{K=0....M-1} w[0][k] \, w[0][k] = t \text{ (par définition)}$$

$$\Sigma_{K=0....M-1} w[0][k] \, w0][(k + p) \text{ modulo } M] = 0 \text{ ou } 1, \text{ pour } p = 1..M\text{-}1$$

En fait, c'est la même définition que pour m = 1.

Les séquences suivantes, w[1...n-m] sont obtenues par

- une autocorrélation cyclique égale à 0 ou t pour des décalages multiples de m (la séquence i décalée d'un multiple de m ne coïncide jamais avec elle-même non décalée) telle que:
  pour tout i = 1...n-m :

$$\Sigma_{K=0....M-1} w[i][k] \, w[i][k] = t \text{ (par définition)}$$

$$\Sigma_{K=0...M-1} w[i][k] \, w[i][(k + p \, m) \text{ modulo } M] = 0, \text{ pour } p = 1..P\text{-}1$$

- par une intercorrélation cyclique égale à 0 ou 1 avec la séquence w[0] (la séquence i décalée ou non ne coïncide avec la séquence 0 qu'en 0 ou 1 point) telle que:
  pour tout i = 1...n-m :

$$\Sigma_{K=0...M-1} w[i][k] \, w[0][(k + p) \text{ modulo } M] = 0 \text{ ou } 1, \text{ pour } p = 0..M\text{-}1$$

- et par une intercorrélation cyclique avec les séquences w[1..n-m] égale à 0 ou 1 pour des décalages multiples de m (la séquence i décalée ou non d'un multiple de m ne coïncide avec la séquence j qu'en 0 ou 1 point) telle que:
  pour toute paire {i, j} où i = 1 ...n-m et j = 1...n-m sont différents :

$$\Sigma_{K=0....M-1} w[i][k] \, w[j][(k + p \, m) \text{ modulo } M] = 0 \text{ ou } 1, \text{ pour } p = 0..P\text{-}1$$

L'algorithme de calcul des séquences w est le même que précédemment. Seuls changent les critères d'autocorrélation et d'intercorrélation, celles-ci n'étant à vérifier que sur P points au lieu de M.

Les colonnes de la matrice A sont alors les vecteurs w permutés circulairement avec un pas égal à 1 ou m telles que:

- Sous-matrice M x M à gauche de A :
  A[ligne][colonne] = w[0][(ligne - colonne) modulo M]
  Avec:
      ligne = 0...M-1
      colonne = 0...M - 1

- Sous-matrices M x P suivantes (en nombre égal à n - m) pour k = m...n-1 :
  A[ligne][colonne] = w[k - m + 1][(ligne - m (colonne - k P)) modulo M]
  Avec:
      ligne = 0...M-1
      colonne = kP...(k + 1)P - 1

Ainsi, chaque ligne de A comporte exactement m = t valeurs non nulles dans ses M premières colonnes, puis 1 valeur non nulle dans chacun des n - m paquets de P colonnes successives, soit un total de n ou tr.

Un exemple de matrice A, obtenu selon la deuxième variante du procédé selon l'invention est montré à la figure 5 pour un code LDPC(75, 30, t=3, tr=5) de redondance 5 / 2 (n = 5, m = 3) avec P = 15. On constate sur le tableau de la figure 5 que:

    w[0][i] = 1 pour = 0, 1, 3
    w[1][i] = 1 pour i = 0, 4, 8
    w[2][i] = 1 pour = 0, 5, 10

Le procédé selon l'invention qui vient d'être décrit sous ses deux variantes conduit directement à un algorithme de codage de symboles de redondance Yi et de symboles d'information Xi très simple.

Pour cela, il suffit de considérer que les symboles de redondance Yi sont les M premiers symboles d'un mot de code, et les symboles libres Xi (information) sont les N - M derniers.

Les équations que doivent vérifier tout mot de code peuvent donc être réécrites sous la forme :

$$\Sigma_{i=0\ldots M\text{-}1}\ Ami\ Yi + \Sigma_{i=M\ldots N\text{-}1}\ Ami\ Xi = 0,\ pour\ m=0\ldots M\text{-}1$$

    ou encore :

$$\Sigma_{i=0\ldots M\text{-}1}\ Ami\ Yi = Zm\ ,\ pour\ m=0\ldots M\text{-}1$$

    avec

$$Zm = -\ \Sigma_{i=M\ldots N\text{-}1}\ Ami\ Xi,\ pour\ m=0\ldots M\text{-}1$$

Le procédé consiste alors à calculer dans un premier temps les M quantités Zm de la matrice de passage, et ensuite les symboles de redondance :

$$Ym = \Sigma_{i=0\ldots M\text{-}1}\ Bmi\ Zi,\ pour\ m=0\ldots M\text{-}1$$

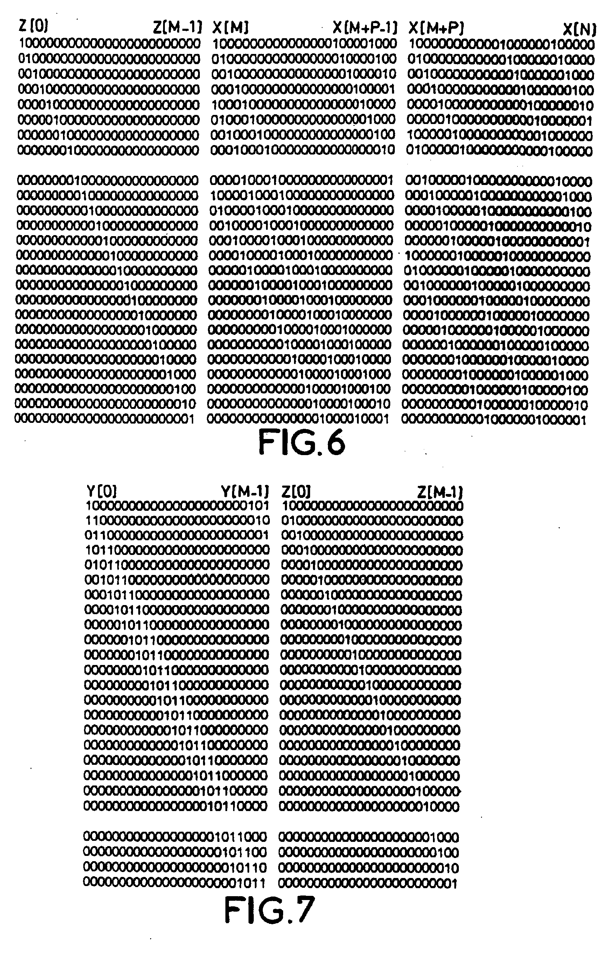

A titre d'exemple, pour le code LDPC(75, 50) les quantités Zm sont calculés par le système d'équation défini par le tableau de la figure 6 qui, après résolution, se transforme en le tableau des symboles de redondance de la figure 7.

La matrice B d'élément générique Bij est l'inverse de la partie gauche $A_M$ (de dimension M x M) de la matrice A. Elle a une forme très simple : par construction, toutes ses colonnes sont des permutations circulaires de la séquence w[0][0..M-1] :
    Aij = w[0][(i - j) modulo M], i=0...M-1, j=0...M-1

La matrice B comporte alors M lignes qui sont des permutations circulaires d'une ligne unique b[0...M-1], à savoir :
    Bij = b[(j - i) modulo M]
    B étant l'inverse de $A_M$, les coefficients b sont définis par :

$$\Sigma_{i=0\ldots M\text{-}1}\ w[0][i]\ b[(i + k)\ modulo\ M] = 1\ si\ k = 0,\ 0\ si\ k = 1\ldots M\text{-}1$$

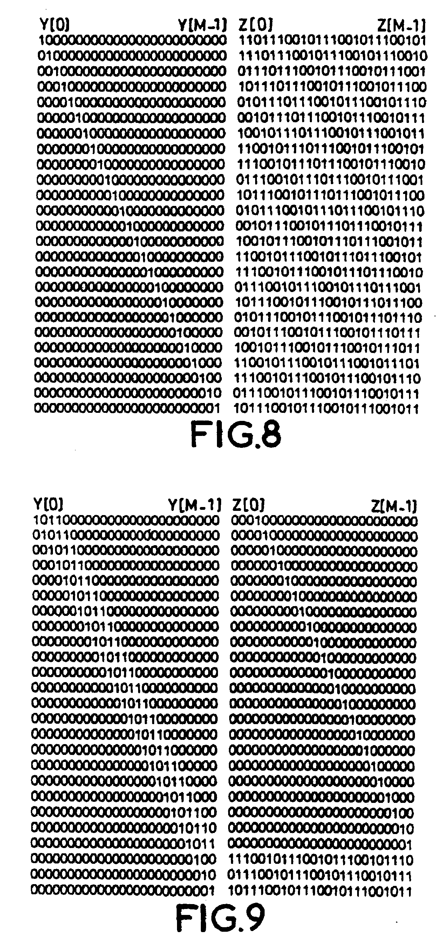

Par exemple, pour le code LDPC(75, 50), les coefficients de redondance Ym sont calculés par le système d'équations défini par le tableau de la figure 8 qui après résolution se transforme en le tableau de la figure 9.

Cependant, il existe des cas où le calcul est impossible.

On peut en effet écrire les équations qui les définissent sous la forme :
    $^{t}A_M$ t{b[0], b[1], ..., b[M-1]} = t{1, 0, 0, ..., 0}

La matrice $^{t}A_M$ est une matrice circulante, dont la première ligne est égale à a[0...M-1] = w[0].

Son déterminant est égal au produit de ses M valeurs propres I0...M-1.

La kéme valeur propre est elle-même donnée par :

$$\lambda_k = \Sigma_{i=0\ldots M\text{-}1}\ a[i]\ \alpha_{ik}$$

où $\alpha$ est une racine Mème de l'unité.

Par exemple:

- pour w[0] = a[0...M-1] = {1, 1, 0, 1, 0, 0, 0, ....}
- pour des codes binaires (on se situe dans le corps de Galois CG(2) où l'addition est équivalente au OU EXCLUSIF (XOR) et la multiplication au ET logique)

on a :

$$\lambda_1 = 1 + \alpha + \alpha^{3.}$$

Si M est multiple de 7, il se trouve que l'équation

$$1 + \alpha + \alpha^3 = 0$$

définit un corps de Galois où $\alpha$ est racine 7ème de l'unité (le polynôme g(x) = 1 + x + x$^3$ est irréductible et primitif dans CG(2) et génère un corps de Galois CG(23)), ce qui signifie que $\lambda_1 = 0$.

Parmi les codes LDPC trouvés par l'algorithme proposé, il faut donc éliminer ceux où M est multiple de 7 si l'on garde ce w[0] ci car :

- l'une des valeurs propres de $^tA_M$ sera nulle
- donc son déterminant sera nul
- donc on ne pourra pas trouver de b[i] convenables
- donc on ne pourra pas effectuer le codage (calculer les Yi)

D'une manière très générale, quel que soit le choix fait pour w[0], il y aura des valeurs de M ne convenant pas car ne permettant pas de faire le codage.

On montre facilement (en factorisant x$^M$ - 1 et a(x) = $\Sigma_{i...M-1}$ a[i] x$^k$) que ces valeurs de M sont les multiples d'une valeur M0 pour laquelle a(x) divise xM0 - 1.

Par exemple, pour des codes binaires avec t = 3:

- w[0] = {1, 1, 0, 1, ...}
- w[0] = {1, 0, 1, 1, ...}

interdisent M multiple de 7 (a(x) définit une racine 7ème de l'unité)

- w[0] = {1, 1, 0, 0, 1, ...}
- w[0] = (1, 0, 0, 1, 1, ...}

interdisent M multiple de 15 (a(x) définit une racine 15ème de l'unité)

- w[0] = {1, 0, 1, 0, 1, ...} n'est pas accepté (autocorrélation incorrecte)
- w[0] = {1, 1, 0, 0, 0, 1, ...}
- w[0] = {1, 0, 0, 0, 1, 1, ...}

interdisent M multiple de 3 (a(x) est multiple de 1 + x + x2 qui définit une racine 3ème de l'unité)

- w[0] = {1, 0, 1, 0, 0, 1, ...}
- w[0] = {1, 0, 0, 1, 0, 1, ...}

interdisent M multiple de 31 (a(x) définit une racine 31ème de l'unité)

Le calcul des coefficients b[i] est effectué de la manière suivante:

Pour une valeur de M non interdite, il existe un algorithme particulièrement simple de calcul des b[i] à partir des a[i] (ou w[0][0...M-1]). Cet algorithme repose sur l'observation que la série des b[i], après périodisation et filtrage par un filtre à réponse impulsionnelle finie (RIF) A(z) dont les coefficients sont les a[M-1, M-2, ..., 1, 0] doit donner la série {1, 0, 0, ...} périodisée. En fait, pour un code binaire utilisant l'un des w[0] énumérés précédemment, cette série est formée de la concaténation de séquences maximales (Maximal Length Sequences) de longueur 7 (ou 15 ou 31 ou 63).

On calcule donc la réponse impulsionnelle du filtre à réponse impulsionnelle infinie (RII) 1 / A(z) et on en extrait une tranche de longueur M qui, une fois périodisée, donne la série {1, 0, 0, ...} après filtrage par A(z).

Par exemple, pour un code binaire avec t = 3 et pour lequel seuls a[0], a[k1] et a[k2] ne sont pas nuls, un algorithme correspondant est fourni à l'annexe 2.

Dans un esprit de simplification pour ne pas effectuer le calcul précédent à chaque codage, l'algorithme de codage peut encore être défini par les k2 derniers éléments b[M-K2...M-1] qui, par récurrence (filtrage par 1 / A(z)) permettent de recalculer tous les autres.

Egalement comme la deuxième phase de l'algorithme de codage standard (calcul des Y à partir des Z) comporte en moyenne $M^2 / 2$ opérations, ce qui peut devenir important pour des codes conséquents : la complexité étant une fonction quadratique de la taille, et que de plus, il est nécessaire de stocker le tableau intermédiaire Z (M éléments) et connaître le tableau b (M éléments aussi) s'il n'est pas calculé sur place, cette partie de l'algorithme peut être modifiée pour n'utiliser que deux tableaux intermédiaires de très petite taille en réécrivant ainsi les équations donnant les Y de la façon montrée par le tableau de la figure 9 (exemple pour un code LDPC(75, 50)) :

Les M - k2 (pour t = 3) premières lignes sont les M - k2 dernières lignes du système d'équations donnant Y, avant résolution.

Les k2 dernières lignes sont les k2 dernières lignes du système d'équations donnant Y, après résolution.

Il suffit alors de calculer les Y dans l'ordre inverse, à savoir Y[M-1], Y[M-2], ..., Y[0].

Le nombre d'opérations à effectuer est alors en moyenne de k2 M / 2 (calcul de Y[M-1] ... Y[M-k2]) suivi de t(M - k2) (calcul de tous les autres) soit approximativement (t + k2/2) M : la complexité n'est plus qu'une fonction linéaire de la taille.

L'algorithme utilise X[M...N] en entrée.

La partie basse de X (X[0...M-1]) est utilisée comme stockage temporaire pour les Z : X[0...M-1] stocke Z [k2...M-1, 0...k2-1] pour éviter un décalage circulaire en phase finale.

Les b[i] sont calculés itérativement sur place, à partir des b[M-k2...M-1].

Le code est défini par deux tableaux :

- le tableau finB[0...k2-1] des k2 derniers éléments de b
- le tableau pos[0...(n - m + 1)t] contenant les positions des éléments non nuls des séquences w[0], w[1], ..., w[n-m].

On utilise deux buffers internes de taille k2 :

- reg[0...k2-1] pour calculer les b[i]
- temp[0...k2-1] pour stocker les valeurs intermédiaires de Y[M-k2...M-1].

L'algorithme complet de codage rapide est alors celui montré à l'annexe 3.

Ces algorithmes sont très simples à mettre en oeuvre. Ils ont entre autre la caractéristique de définir un code par très peu de paramètres, à savoir les (n - m + 1)(t - 1) positions non nulles des "1" dans les séquences w et éventuellement k2 coefficients de codage. Même s'ils ne donnent pas tous les codes possibles répondant aux conditions a-d (par exemple, pas le code (150, 125) de redondance 6/5, qui nécessite n=6 séquences w de longueur P=25), ils en donnent suffisamment pour que, dans une application quelconque où N et K sont définis a priori, on puisse trouver soit

- un code (NLDPC, KLDPC) avec NLDPC = N et KLDPC = K
- un code voisin (NLDPC+d, KLDPC+d), avec d faible, qui sera raccourci par non transmission de d symboles utiles mis arbitrairement à zéro.

Par exemple, pour obtenir un code de (N, K) redondance 5 / 3 (taux 0.6), il suffit de partir d'un code (NLDPC+d, KLDPC+d) de redondance 8 / 5 (taux 0.625) avec d = NLDPC / 15. Pour des valeurs de N inférieures ou égales à 500 et t = 3, il est possible de construire très rapidement 932 codes différents dont les redondances sont les suivantes (on s'est volontairement limité aux redondances comprises entre 4 et 8/7, et aux codes où w[0] = {1, 1, 0, 1, 0, 0, 0, ....} pour lesquels k2 = 3) :

| R = 4/1 | soit 4.000 | (105 codes) |
|---|---|---|
| R = 5/2 | soit 2.500 | (82 codes) |
| R = 6/3 ou 2/1 | soit 2.000 | (203 codes) |

(suite)

| R = 7/4 | soit 1.750 | (55 codes) |
|---|---|---|
| R = 8/5 | soit 1.600 | (47 codes) |
| R = 9/6 ou 3/2 | soit 1.500 | (124 codes) |
| R = 10/7 | soit 1.428 | (34 codes) |
| R = 11/8 | soit 1.375 | (28 codes) |
| R = 12/9 ou 4/3 | soit 1.333 | (84 codes) |
| R = 13/10 | soit 1.300 | (20 codes) |
| R = 14/11 | soit 1.273 | (17 codes) |
| R = 15/12 ou 5/4 | soit 1.250 | (56 codes) |
| R = 16/13 | soit 1.231 | (11 codes) |
| R = 17/14 | soit 1.214 | (7 codes) |
| R = 18/15 ou 6/5 | soit 1.200 | (34 codes) |
| R = 19/16 | soit 1.187 | (3 codes) |
| R = 20/17 | soit 1.176 | (2 codes) |
| R = 21/18 ou 7/6 | soit 1.167 | (17 codes) |
| R = 24/21 ou 8/7 | soit 1.143 | (3 codes) |

De plus, toujours pour une valeur donnée de N inférieure ou égale à 500, il peut y avoir jusqu'à 12 codes différents (pour N = 480).

Par exemple, dès que N est multiple de 6 et supérieur ou égal à 288, il existe toujours trois codes de longueur N et de redondances 6/5, 3/2 et 2/1, par exemple LDPC(300, 250) + LDPC(300, 200) + LDPC(300, 150).

Ceci est très utile pour protéger efficacement un train binaire formé de trois trains binaires chacun de longueur N et de sensibilités différentes.

Bien entendu, il est toujours possible d'envisager de nombreuses variantes de ces algorithmes, comme par exemple une permutation aléatoire des lignes et/ou colonnes de la matrice A.

Il est aussi important de signaler que l'adaptation à des codes non binaires est particulièrement simple.

## ANNEXE 1

```
for(x=0; x<n - m + 1; x++) {
pos[x][0] = 0;
for(pos[x][1]=pos[x][0]+1; pos[x][1]<M-1; pos[x][1]++) {
        for(pos[x][2]=pos[x][1]+1; pos[x][2]<M; pos[x][2]++) {
                (si les conditions ne sont pas satisfaites,
                continuer
                sinon, aller à ok)
            }
        }
        (arrêter : impossible de trouver un choix convenable
        pour pos[x][0...t-1])
    ok:;
    }
```

ANNEXE 2

(langage C : l'opérateur "^" correspond au OU EXCLUSIF.

```
/* Initialisation du passe de b, de longueur M */
for(i=M-k2; i<M; i++)
        b[i] = 0;


/* Calcul de N valeurs successives de la
reponse impulsionnelle de 1/A(z) */
b[0] = 1;
for(i=1; i<k2; i++)
        b[i] = b[(i+M-(k2-k1)) % M] ^ b[(i+M-k2) % M];
for(i=k2; i<M; i++)
        b[i] = b[i-(k2-k1)] ^ b[i-k2];


/* S'arranger pour qu'il n'y ait qu'un 1
dans les k2 dernieres positions de b filtre par A(z) */


weight = 0;    /* tout sauf 1 */


while(weight != 1) {


        /* Decaler d'un cran */
        for(i=1; i<M; i++)
                b[i-1] = b[i];
        b[M-1] = b[M-1-(k2-k1)] ^ b[M-1-k2];
        /* Verifier */
        weight = 0;
        for(i=M-k2; i<M; i++) {
                char   sum = b[i] ^ b[(i+k1) % M] ^ b[(i+k2) % M];
                if(sum) {
                        shift = M - i;
                        weight++;
                }
        }
```

```
        /* Cas particulier ou M est interdit */
        if(weight == 0)
                return(M_FORBIDDEN);
}


/* decalage circulaire final a droite :
b[i] = b[(i - shift) % M] */
for(dec=0; dec < shift; dec++) {
        char    temp = b[M-1];
        for(i=M-1; i>0; i--)
                b[i] = b[i - 1];
        b[0] = temp;
}

return(OK);
```

ANNEXE 3

(langage C) :

```
/* Phase 1 : calcul des M parites intermediaires z.
   Ces parites sont calculees en lisant les colonnes successives de la
matrice de codage, a savoir A[*][M], ..., A[*][N]
   Elles sont mises en tete de x a titre temporaire */

       #define  z      x
          for(i=0; i<M; i++)
                z[i] = 0;


          /* Boucle sur les n-m sous-matrices a la droite de A */
          c0 = M;
          c1 = c0 + P;

          for(k = 1; k <= n - m; k++) {
                offset = 0;
                for(c = c0; c < c1; c++) {
                      if(x[c] != 0)
                            for(i=0; i<t; i++) {
                                  /* p devrait etre offset + pos[i].
                                  On le decremente de k2 pour eviter
le decalage
                                  du tableau z avant la phase 3 */
                                  p = offset + pos[k*t + i]  - k2;
                                  if(p < 0)
                                        z[p + M] = z[p + M] ^ 1;
                                  else
                                        if(p < M)
                                              z[p] = z[p] ^ 1;
                                        else
                                              z[p - M] = z[p - M] ^ 1;
```

```
                    }
            offset = offset + m;
        }
        c0 = c1;
        c1 = c1 + P;
    }


/* Phase 2 : calcul des k2 derniers symboles de parite */
ixb0 = M - 1 - k2;


/* 1 : initialisation des k2 derniers elements de y
temp[0...k2-1] = y[M-1, M-2, ...M-k2] */
for(k=0; k<k2; k++)
        temp[k] = 0;


/* 2 : recopie des k2 derniers elements de b
reg[0...k2-1] = b[M-k2...M-1] */
for(i=0; i<k2; i++)
        reg[i] = finB[i];


/* 3 : calcul iteratif des k2 derniers symboles */
for(i=0; i < M; i++) {
        /* b[i] = {1 0 0 ...} ^ b[i-(k2-k1)] ^ b[i-k2]
        avec b[i-k2]...b[i-1] = reg[0...t2-1]

        On doit verifier :
        b[-k2] + b[k1-k2] + b[0] = 0
        ...
        b[-2] + b[k1-2] + b[k2-2] = 0
        b[-1] + b[k1-1] + b[k2-1] = 0
        b[0] + b[k1] + b[k2] = 1
        b[1] + b[1+k1] + b[1+k2] = 0
        ... */
        if(i == k2)
                input = 1;
```

```
                  else
                        input = 0;
                  bi = input ^ reg[0] ^ reg[k1];
                  for(k=1; k<k2; k++)
                        reg[k - 1] = reg[k];
                  reg[k2 - 1] = bi;

                  if(bi != 0)
                        for(k=0; k<k2; k++)
                              if(z[(ixb0 - k + M) % M] != 0)
                                    temp[k] = temp[k] ^ 1;
                  ixb0 = ixb0 + 1;
                  if(ixb0 == M)
                        ixb0 = 0;
            }


            /* 4 : Les z ont deja ete decales a gauche pour
            eviter l'ecrasement. Sinon, il faudrait faire :

            for(k=0; k<M - k2; k++)
                  z[k] = z[k + k2];


            Recopie de temp a la fin de y */
#define   y       x
            for(k=0; k<k2; k++)
                  y[M - 1 - k] = temp[k];


            /* Phase 3 : calcul de y[M-k2-1, M-k2-2, ..., 0]
            y[k + k2 - k2] + y[k + k2 - k1] + y[k + k2 - 0] + z[k + k2] = 0
            y[k] va en x[k]
            z[k + k2] est en x[k]
            Donc :
            x[k + k2 - k2] + x[k + k2 - k1] + x[k + k2 - 0] + x[k] = 0
            Soit :
            x[k + k2 - k2] = -(x[k + k2 - k1] + x[k + k2] + x[k])
```

```
*/
for(k = M - k2 - 1; k >= 0; k--)
        y[k] = y[k + k2 - k1] ^ y[k + k2] ^ z[k];
```

**Revendications**

**1.** Procédé de construction de codes LDPC pour la protection de trains binaires d'information, chaque train étant composé de N symboles décomposés en N-M symboles d'informations utiles $X_i$ et M symboles d'informations de redondance $Y_m$, chaque code étant défini par une matrice de contrôle A comportant M=N-K lignes de N colonnes et t symboles non nuls dans chaque colonne, caractérisé en ce qu'il consiste :

- à attribuer à toutes les lignes de la matrice de contrôle A un même nombre de symboles non nuls,
- à prendre comme nombre de symboles t un nombre impair le plus petit possible,
- à définir les colonnes de façon que deux colonnes quelconques de la matrice de contrôle A n'aient au plus qu'une valeur non nulle,
- et à définir les lignes de façon que deux lignes de la matrice de contrôle A n'aient qu'une valeur commune non nulle.

**2.** Procédé selon la revendication 1 caractérisé en ce qu'il consiste:

- à subdiviser la matrice de contrôle A de M lignes et N colonnes en n sous matrice de M lignes et P colonnes pour former n sous matrices de P lignes et P colonnes et à regrouper les $m^2$ sous matrices de gauche en une sous matrice MxM et les autres en n-m sous matrice MxP,
- et à déterminer Mxn séquences de vecteurs colonne w[0....n-1] de longueur M comportant t valeurs non nulles et (M-t) valeurs nulles en effectuant une autocorrélation et une intercorrélation cyclique des vecteurs colonne w.

**3.** Procédé selon la revendication 1 caractérisé en ce qu'il consiste :

-- à subdiviser la matrice de contrôle A de M lignes et N colonnes en n sous matrices de M lignes et P colonnes pour former nxm sous matrices de P lignes et P colonnes et à regrouper les $m^2$ sous matrices de gauche en une sous matrice MxM et les autres en n-m sous matrice MxP,

- à déterminer n-m+1 séquences de vecteurs colonnes w[0....n-m] de longueur M comportant t valeurs non nulles et (M-t) valeurs nulles,
- la première séquence w[0] étant obtenue par autocorrélation cyclique égale à 0, 1, ou à la valeur t de façon que la séquence w[0] décalée ne coïncide avec elle même non décalée qu'en 0 ou 1 point,
- les n-m séquences suivantes w[i][k] étant obtenues :

  - par une autocorrélation cyclique de valeur nulle ou égale à la valeur t de façon que la valeur de la séquence w[i] décalée d'un multiple de m ne coïncide jamais avec elle-même non décalée,et par une intercorrélation cyclique
  - et par une intercorrélation cyclique de valeur nulle ou 1 avec les séquences w[1....n-m] pour des décalages multiples de m de façon que une séquence i décalée ou non d'un multiple de m ne coïncide avec la séquence j qu'en 0 ou 1 point.

**4.** Procédé selon l'une quelconque des revendications 1 à 4 caractérisé en ce qu'il consiste à déterminer pour le codage d'informations utiles $X_i$, une matrice de passage $Z_m$ égale au produit de la matrice de contrôle A par un vecteur colonne représentant N-M symboles d'information $X_i$ et à adjoindre aux symboles d'information des symboles de redondance $Y_m$ obtenus en résultat du produit de la matrice de passage $Z_m$ par une matrice B égale à l'inverse de la partie de dimension MxM de la matrice de contrôle A.

FIG.1

FIG.2

FIG.3

W0    ↓t        W1        W2

```
1000000000000000000000101   1000000000000000100001000   1000000000001000000100000
1100000000000000000000010   0100000000000000010000100   0100000000000100000010000
0110000000000000000000001   0010000000000000001000010   0010000000000010000001000
1011000000000000000000000   0001000000000000000100001   0001000000000001000000100
0101100000000000000000000   1000100000000000000010000   0000100000000000100000010
0010110000000000000000000   0100010000000000000001000   0000010000000000010000001
0001011000000000000000000   0010001000000000000000100   1000001000000000001000000
0000101100000000000000000   0001000100000000000000010   0100000100000000000100000
0000010110000000000000000   0000100010000000000000001   0010000010000000000010000
0000001011000000000000000   1000010001000000000000000   0001000001000000000001000
0000000101100000000000000   0100001000100000000000000   0000100000100000000000100
0000000010110000000000000   0010000100010000000000000   0000010000010000000000010
0000000001011000000000000   0001000010001000000000000   0000001000001000000000001
0000000000101100000000000   0000100001000100000000000   1000000100000100000000000
0000000000010110000000000   0000010000100010000000000   0100000010000010000000000
0000000000001011000000000   0000001000010001000000000   0010000001000001000000000
0000000000000101100000000   0000000100001000100000000   0001000000100000100000000
0000000000000010110000000   0000000010000100010000000   0000100000010000010000000
0000000000000001011000000   0000000001000010001000000   0000010000001000001000000
0000000000000000101100000   0000000000100001000100000   0000001000000100000100000
0000000000000000010110000   0000000000010000100010000   0000000100000010000010000
0000000000000000001011000   0000000000001000010001000   0000000010000001000001000

0000000000000000000101100   0000000000000100001000100   0000000010000001000000100
0000000000000000000010110   0000000000000000000100010   0000000001000000100000010
0000000000000000000001011   0000000000000000000010001   0000000000100000010000001
```

## FIG.4

W0                M            W1    P    W2    P

```
1000000000000000000000000000000000000101   00000000000000   00000000000000
1100000000000000000000000000000000000010   00000000000001   00000000000100
0110000000000000000000000000000000000001   00000000000010   00000000000001
1011000000000000000000000000000000000000   01000000000000   01000000000000
0101100000000000000000000000000000000000   10000000000000   00000000000010
0010110000000000000000000000000000000000   00000000000001   10000000000000
0001011000000000000000000000000000000000   00100000000000   00100000000000
0000101100000000000000000000000000000000   01000000000000   00000000000001
0000010110000000000000000000000000000000   10000000000000   01000000000000
0000001011000000000000000000000000000000   00010000000000   00100000000000
0000000101100000000000000000000000000000   00100000000000   10000000000000
0000000010110000000000000000000000000000   01000000000000   00100000000000
0000000001011000000000000000000000000000   00001000000000   00010000000000
0000000000101100000000000000000000000000   00010000000000   01000000000000
0000000000010110000000000000000000000000   00100000000000   00100000000000
0000000000001011000000000000000000000000   00000100000000   00001000000000
0000000000000101100000000000000000000000   00010000000000   00100000000000
0000000000000010110000000000000000000000   00001000000000   00010000000000
0000000000000001011000000000000000000000   00000100000000   00000100000000
0000000000000000101100000000000000000000   00010000000000   00100000000000
0000000000000000010110000000000000000000   00000010000000   00010000000000
0000000000000000001011000000000000000000   00010000000000   00000010000000
0000000000000000000101100000000000000000   00000001000000   00000001000000

0000000000000000000000000000000000101100   00000000000001   00000000000001
0000000000000000000000000000000000010110   00000000000010   00000000001000
0000000000000000000000000000000000001011   00000000000100   00000000000010
```

## FIG.5

EP 1 093 231 A1

Z [0]                          Z[M-1] X[M]                          X[M+P-1] X[M+P]                          X[N]
10000000000000000000000000     10000000000000000100001000     10000000000001000000100000
01000000000000000000000000     01000000000000010000100     01000000000001000000010000
00100000000000000000000000     00100000000000001000010     00100000000010000001000
00010000000000000000000000     00010000000000000100001     00010000000001000000100
00001000000000000000000000     10001000000000000010000     00001000000000100000010
00000100000000000000000000     01000100000000000001000     00000100000000010000001
00000010000000000000000000     00100010000000000000100     10000010000000001000000
00000001000000000000000000     00010001000000000000010     01000001000000000100000

00000000100000000000000000     00001000100000000000001     00100000100000000010000
00000000010000000000000000     10000100010000000000000     00010000010000000001000
00000000001000000000000000     01000010001000000000000     00001000001000000000100
00000000000100000000000000     00100001000100000000000     00000100001000000000010
00000000000010000000000000     00010001000100000000000     00000010000100000000001
00000000000001000000000000     00001000010001000000000     10000001000010000000000
00000000000000100000000000     00001000010001000000000     01000001000010000000000
00000000000000010000000000     00000100001000100000000     00100000010000010000000
00000000000000001000000000     00000100001000100000000     00010000010000010000000
00000000000000000100000000     00000010000100010000000     00001000001000010000000
00000000000000000010000000     00000001000010001000000     00000100000010000010000000
00000000000000000001000000     00000001000010001000000     00000100000010000010000000
00000000000000000000100000     00000000100010001000000     00000010000001000010000000
00000000000000000000010000     00000000010000100010000     00000001000001000010000
00000000000000000000001000     00000000010000100010000     00000001000000100000010000
00000000000000000000000100     00000000001000010001000     00000000100000100000100
00000000000000000000000010     00000000000100001000100     00000000010000010000010
00000000000000000000000001     00000000000001000010001     00000000000010000001000001

# FIG.6

Y [0]                          Y[M-1] Z[0]                          Z[M-1]
10000000000000000000000101     10000000000000000000000000
11000000000000000000000010     01000000000000000000000000
01100000000000000000000001     00100000000000000000000000
10110000000000000000000000     00010000000000000000000000
01011000000000000000000000     00001000000000000000000000
00101100000000000000000000     00000100000000000000000000
00010110000000000000000000     00000010000000000000000000
00001011000000000000000000     00000001000000000000000000
00000101100000000000000000     00000000100000000000000000
00000010110000000000000000     00000000010000000000000000
00000001011000000000000000     00000000001000000000000000
00000000101100000000000000     00000000000100000000000000
00000000010110000000000000     00000000000010000000000000
00000000001011000000000000     00000000000001000000000000
00000000000101100000000000     00000000000000100000000000
00000000000010110000000000     00000000000000010000000000
00000000000001011000000000     00000000000000001000000000
00000000000000101100000000     00000000000000000100000000
00000000000000010110000000     00000000000000000010000000
00000000000000001011000000     00000000000000000001000000
00000000000000000101100000     00000000000000000000100000
00000000000000000010110000     00000000000000000000010000

00000000000000000001011000     00000000000000000000001000
00000000000000000000101100     00000000000000000000000100
00000000000000000000010110     00000000000000000000000010
00000000000000000000001011     00000000000000000000000001

# FIG.7

17

| Y[0] | Y[M-1] | Z[0] | Z[M-1] |
|---|---|---|---|

```
Y[0]                       Y[M-1]  Z[0]                      Z[M-1]
100000000000000000000000   110111001011100101110011
010000000000000000000000   111011100101110010111001 0
001000000000000000000000   011101110010111001011100 1
000100000000000000000000   101110111001011100101110 0
000010000000000000000000   010111011100101110010111 0
000001000000000000000000   001011101110010111001011 1
000000100000000000000000   100101110111001011100101 1
000000010000000000000000   110010111011100101110010 1
000000001000000000000000   111001011101110010111001 0
000000000100000000000000   011100101110111001011100 1
000000000010000000000000   101110010111011100101110 0
000000000001000000000000   010111001011101110010111 0
000000000000100000000000   001011100101110111001011 1
000000000000010000000000   100101110010111011100101 1
000000000000001000000000   110010111001011101110010 1
000000000000000100000000   111001011100101110111001 0
000000000000000010000000   011100101110010111011100 1
000000000000000001000000   101110010111001011101110 0
000000000000000000100000   001011100101110010111011 1
000000000000000000010000   100101110010111001011101 1
000000000000000000001000   110010111001011100101111 0
000000000000000000000100   111001011100101110010111 0
000000000000000000000010   011100101110010111001011 1
000000000000000000000001   101110010111001011100101 1
```

# FIG.8

```
Y[0]                       Y[M-1]  Z[0]                      Z[M-1]
101100000000000000000000   000100000000000000000000
010110000000000000000000   000010000000000000000000
001011000000000000000000   000001000000000000000000
000101100000000000000000   000000100000000000000000
000010110000000000000000   000000010000000000000000
000001011000000000000000   000000001000000000000000
000000101100000000000000   000000000100000000000000
000000010110000000000000   000000000010000000000000
000000001011000000000000   000000000001000000000000
000000000101100000000000   000000000000100000000000
000000000010110000000000   000000000000010000000000
000000000001011000000000   000000000000001000000000
000000000000101100000000   000000000000000100000000
000000000000010110000000   000000000000000010000000
000000000000001011000000   000000000000000001000000
000000000000000101100000   000000000000000000100000
000000000000000010110000   000000000000000000010000
000000000000000001011000   000000000000000000001000
000000000000000000101100   000000000000000000000100
000000000000000000010110   000000000000000000000010
000000000000000000001011   000000000000000000000001
000000000000000000000100   111001011100101110010111 0
000000000000000000000010   011100101110010111001011 1
000000000000000000000001   101110010111001011100101 1
```

# FIG.9

Office européen
des brevets

**RAPPORT DE RECHERCHE EUROPEENNE**

Numéro de la demande

EP 00 40 2797

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| D,A | MACKAY D J C: "Good error-correcting codes based on very sparse matrices" IEEE TRANSACTIONS ON INFORMATION THEORY, MARCH 1999, IEEE, USA, vol. 45, no. 2, pages 399-431, XP002143042 ISSN: 0018-9448 * le document en entier * | 1-4 | H03M13/25 |
| A | LI PING ET AL: "Low density parity check codes with semi-random parity check matrix" ELECTRONICS LETTERS, 7 JAN. 1999, IEE, UK, vol. 35, no. 1, pages 38-39, XP002143043 ISSN: 0013-5194 * le document en entier * | 1-4 | |
| A | PENG X -H ET AL: "EFFICIENT PERMUTATION CRITERION FOR OBTAINING MINIMAL TRELLIS OF A BLOCK CODE" ELECTRONICS LETTERS,GB,IEE STEVENAGE, vol. 32, no. 11, 23 mai 1996 (1996-05-23), pages 983-984, XP000599121 ISSN: 0013-5194 * le document en entier * | 1-4 | **DOMAINES TECHNIQUES RECHERCHES** (Int.Cl.7) <br> H03M |
| A | BOUTROS J ET AL: "Generalized low density (Tanner) codes" 1999 IEEE INTERNATIONAL CONFERENCE ON COMMUNICATIONS (CAT. NO. 99CH36311), 1999 IEEE INTERNATIONAL CONFERENCE ON COMMUNICATIONS, VANCOUVER, BC, CANADA, 6-10 JUNE 1999, pages 441-445 vol.1, XP002143044 1999, Piscataway, NJ, USA, USA ISBN: 0-7803-5284-X * le document en entier * | 1-4 | |

-/--

Le présent rapport a été établi pour toutes les revendications

| Lieu de la recherche | Date d'achèvement de la recherche | Examinateur |
|---|---|---|
| LA HAYE | 1 février 2001 | Barel-Faucheux, C |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
& : membre de la même famille, document correspondant

EPO FORM 1503 03.82 (P04C02)

Office européen
des brevets

**RAPPORT DE RECHERCHE EUROPEENNE**

Numéro de la demande

EP 00 40 2797

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|-----------|------------------------------------------------------------------------------|-------------------------|-------------------------------------|
| A | US 5 537 427 A (CHEN CHIN-LONG) 16 juillet 1996 (1996-07-16) * le document en entier * --- | 1-4 | |
| A | RICHARD E. BLAHUT: "Theory and practice of error control codes ISBN: 0-201-10102-5" mai 1984 (1984-05) , ADDISON-WESLEY , UNITED STATES XP002143045 * page 47 - page 49 * ----- | 1-4 | |
| | | | DOMAINES TECHNIQUES RECHERCHES (Int.Cl.7) |

Le présent rapport a été établi pour toutes les revendications

| Lieu de la recherche | Date d'achèvement de la recherche | Examinateur |
|----------------------|-----------------------------------|-------------|
| LA HAYE | 1 février 2001 | Barel-Faucheux, C |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

 

& : membre de la même famille, document correspondant

EPO FORM 1503 03.82 (P04C02)

ANNEXE AU RAPPORT DE RECHERCHE EUROPEENNE
RELATIF A LA DEMANDE DE BREVET EUROPEEN NO.

EP 00 40 2797

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

01-02-2001

| Document brevet cité au rapport de recherche | Date de publication | Membre(s) de la famille de brevet(s) | Date de publication |
|---|---|---|---|
| US 5537427 A | 16-07-1996 | US 5537423 A | 16-07-1996 |

Pour tout renseignement concernant cette annexe : voir Journal Officiel de l'Office européen des brevets, No.12/82